# EUROPEAN PATENT SPECIFICATION

(11) **EP 0 999 536 B1**
(45) Date of publication and mention of the grant of the patent: **14.12.2005**
(21) Application number: 97943144.2
(22) Date of filing: 02.10.1997
(51) Int. Cl.: G09F 9/00, H01J 5/16, H01J 7/16, G02B 5/28, G02B 1/10, H05K 9/00

(54) **OPTICAL FILTER FOR DISPLAY PANEL**
OPTISCHES FILTER FÜR ANZEIGETAFEL
FILTRE OPTIQUE POUR ECRAN D'AFFICHAGE

(30) Priority: 20.05.1997 JP 12935597; 20.05.1997 JP 12935697
(43) Date of publication of application: 10.05.2000
(73) Proprietor: FUJITSU GENERAL LIMITED, Kawasaki-shi, Kanagawa-ken 213-0013 (JP)
(72) Inventor: SATO, Hiroki, Kawasaki-shi Kanagawa-ken 213 (JP)
(74) Representative: Skone James, Robert Edmund
(86) International application number: PCT/JP1997/003533
(87) International publication number: WO 1998/053439

(56) References cited:
- EP-A- 0 782 164
- JP-A- 2 079 083
- JP-A- 7 178 866
- JP-U- 62 199 999
- US-A- 5 811 923

## Description

### TECHNICAL FILED

The present invention relates to an optical filter for display panel (hereinafter referred to simply as optical filter) to be installed in front of the display panel for intercepting the electromagnetic wave leaking from the display panel and for cutting off the near-infrared ray radiated from the same display panel.

### BACKGROUND ART

As display panel to be used as image display device there is a gas-charge display panel such as plasma display panel (PDP). The PDP is designed to excite the molecules of the gas sealed therein by electric discharge between the electrodes, more particularly, to excite the molecules of xenon gas, which is mixed with neon gas for facilitating the excitation of xenon gas molecules, thereby causing the fluorescent substance applied on interior thereof to be excited by generated ultraviolet ray to emit visible rays for display of image, but, on the other hand, the sustain current flowing across the electrodes generates a magnetic filed which mainly causes the generation of electromagnetic wave having frequency of 30MHz - 130MHz or less in the PDP which leaks outside the PDP.

Further, the xenon gas, when excited, generates near-infrared ray besides ultraviolet ray, and, since the wavelength of the near-infrared ray is approximate to central wavelength, about 900nm, of emission spectrum of light-emitting diode (hereinafter referred to simply as LED), there is the possibility of the erroneous operation of remote control equipment or optical communication equipment caused by near-infrared ray radiated from the PDP when such equipment is operated near the PDP.

For this reason an optical filter is placed in front of the PDP for intercepting the electromagnetic wave leaking from PDP and for cutting of near-infrared ray radiated from the same. Such leak of the electromagnetic wave within a predetermined frequency range is prevented, for example, by forming an electromagnetic wave intercepting layer of reticulate conductor on the surface of a filter substrate formed from a synthetic resin such as acrylic resin. In such a case, not only the width and interval of the reticulate conductor are determined but also the direction of the reticulate is arranged diagonally so that image light from PDP will not be intercepted. Further, for cutting off the near-infrared ray, the radiation of near-infrared ray is cut off by providing a layer of infrared ray absorption glass or plastic-base infrared ray absorption filter.

The optical filter such as one described above is of the combination of layers for intercepting electromagnetic wave and layers for cutting of near-infrared ray which are manufactured separately, thereby causing the problem of high manufacturing cost.

Further, it is unavoidable for the image light to be disturbed by the electromagnetic wave intercepting layer of reticulate conductor, causing darkening and degrading (due to occurrence of Newton's rings or blur of image) of picture quality.

Further, the optical filter having filter substrate formed from synthetic resin such as acrylic resin has a problem that the optical filter tends to warp locally due to the heat given off from the display panel while being used for display, adversely affecting the quality of displayed picture. In particular, since PDP gives off heat resulting from the electric discharge for display of image, in a large-size PDP display device having a gap provided between the optical filter and the PDP (e.g., 24-inch PDP display device), it is known that local warp or deflection of optical filter due to the heat caused by the electric discharge in PDP adversely affects the quality of displayed picture.

Further, where Ag film, as a transparent conductive film for intercepting the electromagnetic wave and cutting off near-infrared ray, is formed on a filter substrate by sputtering method, there is a problem that sputtered silver film is apt to be corroded by water vapor and the like in the air when its surface is exposed to the air.

US4859532 discloses a transparent laminated product for preventing leakage of electromagnetic waves generated by computer equipment and the like. The laminated product comprises a transparent substrate and a coating of transparent oxide and silver layers alternately laminated. The laminated layers have a surface resistance less than or equal to 10Ω/cm².

JP-A-2079083 discloses an optical member for a plasma display screen wherein the optical member is grounded.

EP-A-0782164 discloses a plasma display filter for cutting off infrared rays radiated from a plasma display.

The present invention is made in consideration of the problems described above and has an object to obtain an optical filter for display panel capable of transmission of image light (visible rays) output from a display panel (e.g., a PDP), intercepting the electromagnetic waves within a frequency range of 30MHz - 130MHz leaking from display panel and cutting off the near-infrared ray within wavelength range of 800nm - 1000nm radiated from display panel at low cost.

Further objects of the present invention are to reduce the weight and thickness of optical filter, to prevent optical filter from being warped locally due to the heat given off from display panel, to prevent transparent conductive film (especially silver film) provided on the transparent substrate from being corroded by water vapor in the air, to prevent the decline of contrast due to the deflection of external light, to correct colors developed on display panel, to prevent occurrence of Newtons ring (alternate occurrence of bright and dark concentric rings), to prevent glass substrate, used as a transparent substrate, from scattering in pieces when broken, to design for easier installation into a display panel and the like.

### DISCLOSURE OF THE INVENTION

The optical filter according to the present invention is an optical filter to be disposed in front of a display panel. The optical filter comprises a filter substrate formed from glass or from reinforced glass and a transparent conductive film for transmitting visible electromagnetic waves and intercepting electromagnetic waves having a frequency of 30 MHZ - 130 MHZ and cutting off near-infrared electromagnetic waves having a wavelength of 800 nm - 1000 nm, the transparent conductive film comprising thin silver films and thin zinc oxide films which are laid alternatively to form a multilayer film, characterised in that the multilayer film has a surface resistance of 3Ω/cm² or less, in that the transparent conductive film is connectable to a grounding electrode, and in that the corners of the filter substrate, each formed between a wider surface and a side surface thereof, are bevelled.

The transparent conductive film allows the visible rays output from the display panel to transmit but intercepts the electromagnetic wave leaking from display panel and cut off the near-infrared ray radiated from the same. Moreover, the transparent conductive film being formed into a multilayer film by alternately laying thin silver films and thin zinc oxide films, the manufacturing cost thereof can be made lower than that of the transparent film according to prior art which is manufactured by combining separately formed electromagnetic wave intercepting layers and near-infrared ray cutoff layers.

By forming the transparent conductive film with thin silver films and thin zinc oxide films laid alternately, the transmissivity of image light (visible rays) output from the display panel can be set above predetermined value (e.g., 60%), and by setting surface resistance of the transparent conductive film to 3Ω/cm² (3 ohm per 1 square cm) or less, not only the interception effect (attenuation effect) of the electromagnetic wave within frequency range of 30MHz- 130MHz can be set above predetermined value (e.g., 10 decibel) but also the transmissivity of near-infrared ray having wavelength within 800nm - 1000nm can be set below predetermined value (e.g., 10%).

Electromagnetic waves are intercepted efficiently by the grounding of the transparent conductive film through the grounding electrode connected thereto for discharging the electric charge induced in the transparent conductive film.

Local warp or deflection of the optical filter caused by the heat given off from display panel is prevented by using the glass or reinforced glass filter substrate, thereby also preventing degrading of displayed picture quality.

By using filter substrate of reinforced glass, the reduction of thickness for filter substrate and optical filter can be realized.

Handling of the glass or reinforced glass filter substrate is made easier by beveling the corner formed between its wider surface and its side surface.

White balance can be maintained easier by providing colored film so that the colors developed on display panel can be corrected. The colored film for correcting colors developed on display panel may be securely attached to the surface of filter substrate and its edges may be beveled to continue flush with the beveled corner of the filter so that the colored film will not peel off during handling of the filter substrate.

A reflection-proof film for preventing reflection of external light by the surface of colored film may be provided on the surface of the colored film so that the colored film acquires a function for correcting colors developed on the display panel and a function for preventing reduction of contrast due to reflection of external light.

Corrosion of transparent conductive film (especially, thin silver film) by water vapor in the air can be prevented by providing a moisture-proof film covering exposed surface of the transparent conductive film.

Decline of contrast due to reflection of external light or image light can be prevented by providing a anti-reflection film.

### BRIEF DESCRIPTION OF DRAWINGS

Fig. 1 is a schematic diagram illustrating an optical filter according to the first embodiment of the present invention installed in a PDP display device.
Fig. 2 is an enlarged exploded view of the optical filter of Fig. 1.
Fig. 3 shows an enlarged view of a part of diagram and another enlarged view of a part of first enlarged view of Fig. 1.
Fig. 4 is an enlarged cross-sectional view of principal part of transparent conductive film of Fig. 2.
Fig. 5 is a transmissivity characteristics of visible rays and near-infrared ray to the transparent conductive film shown in Fig. 1 through Fig. 4.
Fig. 6 is a schematic diagram illustrating the optical filter for display panel according to the second embodiment of the present invention installed in a PDP display panel.
Fig. 7 is an enlarged view of a part of Fig. 6.
Fig. 8 is a partial enlarged view showing the optical filter for display panel according to the third embodiment of the present invention installed in a PDP display device.

### BEST MODES FOR CARRYING OUT THE INVENTION

The present invention will be described in detail referring to accompanying drawings.

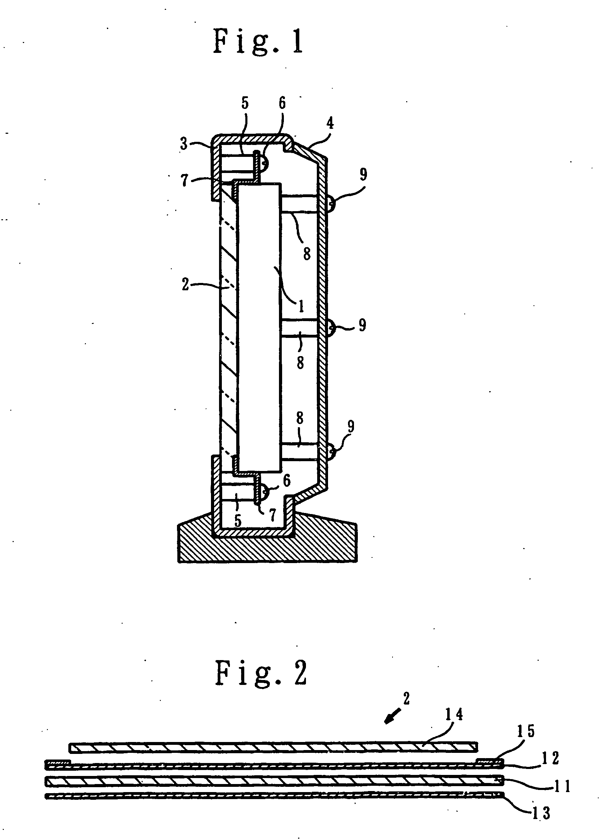

First, the optical filter for display panel according to the first embodiment of the present invention will be described referring to Fig. 1 through Fig. 5.

Fig. 1 shows an example of the optical filter used in a small-size PDP display device (e.g., 21-inch PDP display device), wherein numeral 1 denotes PDP, 2 for optical filter of PDP (hereinafter referred to simply as optical filter), 3 for front portion of casing and 4 for rear portion of the casing. One side of fixing metal member 7 abuts peripheral portion of the optical filter 2, while the other side of the fixing metal member 7 is securely attached to a fixing boss 5 with a screw 6, whereby the optical filter 2 is fixed to the front portion 3 of the casing. The PDP 1 is fixed to the rear portion 4 of the casing with a screw 9 through the fixing boss 8, and the rear portion 4 of the casing is fixed to the front portion 3 of the casing, whereby the peripheral portion of the PDP 1 is made to abut the fixing metal member 7 so that the fixing metal member 7 is made to come into contact strongly with the peripheral portion of the optical filter 2.

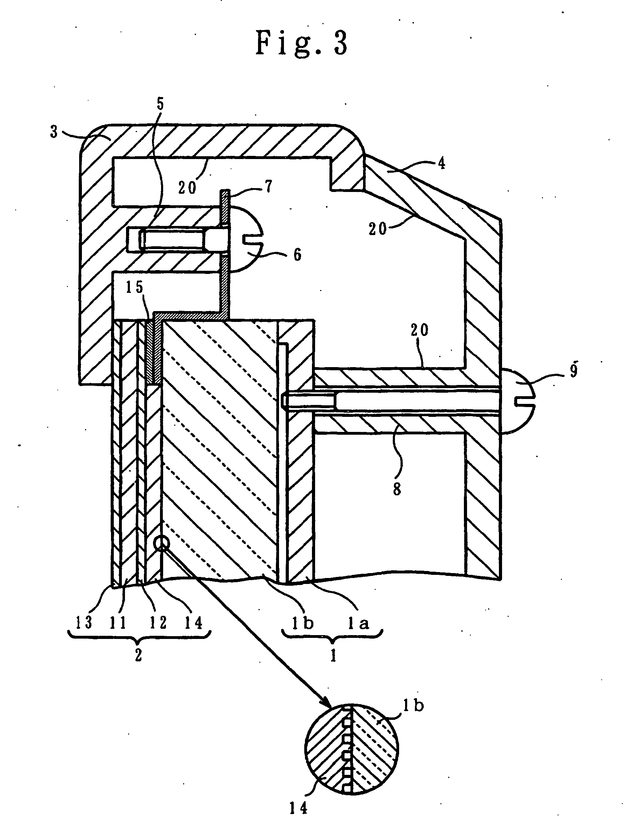

As shown in Fig. 2 and Fig. 3, the optical filter 2 comprises a filter substrate 11 formed from colored synthetic resin substrate, a transparent conductive film as a sputter film 12 attached on one surface (surface on the side of PDP 1) of the filter substrate 11 with a bonding agent (or adhesive) (the same applies hereinafter), an AR (Anti-Reflection) film 13 attached on the other surface of the filter substrate 11 with a bonding agent, an AN (Anti-Newton's rings) film 14 attached on the surface of the transparent conductive film as a sputter film 12 with the bonding agent and a grounding electrode 15 formed with a conductive metal print within the outer area of the AN film corresponding to the peripheral area of the transparent conductive film as a sputter film 12.

The filter substrate 11 is formed from a colorless transparent synthetic resin having an adequate impact strength, such as acrylic resin or polycarbonate, mixed with a pigment serving as a selective filter capable of absorbing red color component for correcting the colors developed by the PDP 1 by absorbing the red color component that is developed slightly together with the blue color developed by fluorescent substance used for development of blue color. More particularly, (the filter substrate 11) is formed into a substrate having a specified thickness (e.g., 2 mm thick) from liquid acrylic resin or polycarbonate mixed with a specified pigment by using a mold.

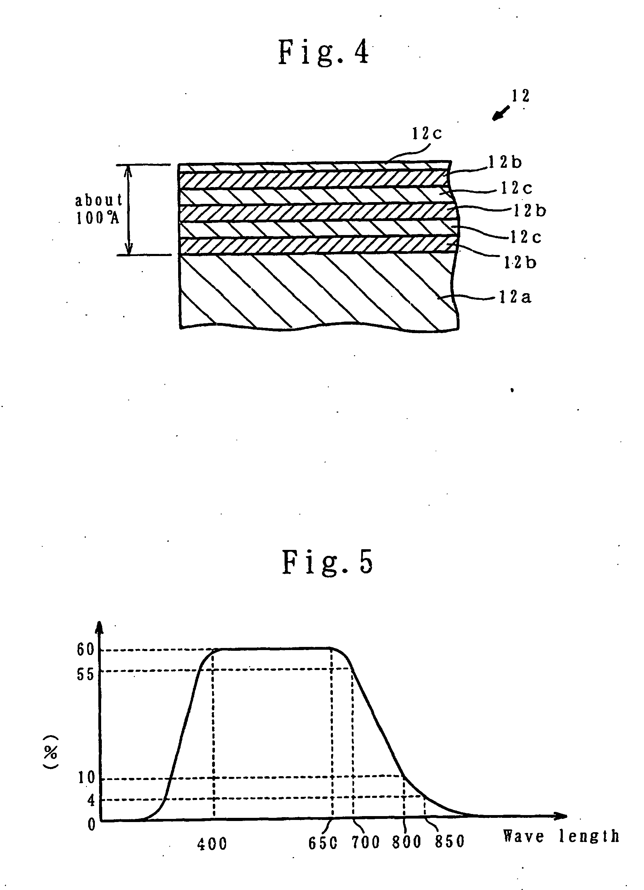

As shown in Fig. 4, the transparent conductive film as a sputter film 12 is formed to have a thickness (e.g., about 100 Å) for providing a surface resistance of about 2.7 Ω/cm² (2.7 ohm per 1 square cm) with a transparent PET (Polyethylene Terephthalate) film 12a and a multilayer film comprising thin silver (Ag) films 12b and thin zinc oxide (ZnO) films formed by sputtering, which are laid alternately on one surface of the transparent PET film so that a thin zinc oxide film 12c forms the outermost layer. In this case, the greater the number of layers of thin silver films 12b and thin zinc oxide films 12c, the smaller the surface resistance, causing the increase in the intercepted amount of electromagnetic wave and the decrease in the transmissivity of visible rays, while the smaller the number of layers of the thin silver films 12b and zinc oxide films 12c, the greater the transmissivity of the visible rays but greater the surface resistance, causing the decrease in intercepted amount of electromagnetic wave. For this reason, the surface resistance is set to about 2.7 Ω/cm² in order to intercept the electromagnetic wave to a level required by safety standard, but maintaining the transmissivity of visible rays at the predetermined level (e.g., 60%) or more.

The AR film 13 is for preventing reflection of external light and comprises, for example, a transparent film whose surface is covered with a vapor deposition layers of materials having different refractive indexes or a transparent film whose surface is covered with a fluororesin, thereby making the external light such as incident light refract in a complex way to prevent the reflection thereof as much as possible for preventing decline of contrast.

As shown in the enlarged diagram of Fig. 3, the AN film 14 is formed by using a colorless transparent film having fine unevenness on one of its surface (surface on the side of PDP 1) so that an optical film can be prevented from coming into close contact with the surface of the PDP 1 because of the surface unevenness, thereby preventing the occurrence of Newton's rings (development of bright and dark concentric circles) when the optical filter is disposed in contact with the PDP 1.

The surface of fixing boss 5, inside surface of front portion 3 of the casing, inside surface of rear portion 4 of the casing, surface of fixing boss 8 and the like are formed with conductive film 20, whereby the transparent conductive film 12 of the optical filter 2 is connected to metal member (grounding member) 1a, constituting the back of the PDP 1, through grounding electrode 15, fixing metal member 7 and conductive film 20 to discharge to the ground the electric charge induced in the transparent conductive film 12 by the electromagnetic wave radiated from the body 1b of the PDP 1.

As shown in Fig. 1 and Fig. 3, when the optical filter 2 is placed on the front surface of PDP 1, the image light (visible rays) output from PDP 1 passes through the optical filter 2, and the electromagnetic wave leaking from PDP 1 is intercepted by the optical filter 2, while the near-infrared ray radiated from PDP 1 is cut off by the optical filter 2. According to the result of experiment, the amount of electromagnetic wave intercepted (amount of attenuation) by the optical filter is 10 dB (dB µV/m) or more within frequency range of 30MHz - 130MHz. Therefore, when the electromagnetic wave intercepting ability of PDP 1 itself is combined with (that available with the optical filter), the available electromagnetic wave intercepting ability is large enough for clearing the allowable leakage levels set by the Electrical Equipment Control Law, VCCI (Voluntary Control Council for Interference by Data Processing Equipment and Electronic Office Machines of Japan), FCC (Federal Communication Committee), EN (European Standards) and the like. The transmissivities of visible rays and near-infrared ray are as shown in Fig. 5. More particularly, the transmissivity of visible ray whose wavelength is within 400nm - 700nm is about 60%; about 10% (i.e., cutoff by 90%) for near-infrared ray whose wavelength is 800nm; about 10% - 4% (i.e., cutoff by 90% - 96%) for near-infrared ray whose wavelength is within 800nm - 850nm; about 4% (i.e., cutoff by 96% or more) for near-infrared ray whose wavelength is 850nm or more. Therefore, the interference with the operation of infrared-ray remote control equipment or optical communication equipment by infrared ray can be prevented.

Further, the sputter film 12, as a transparent conductive film, having a multilayer structure comprising thin silver films 12b and thin zinc oxide films 12c laid alternately, the fine particles of zinc oxide in the thin film 12c diffusely reflects the incident light from forward, while the thin silver film serves as a regular reflector, thereby preventing the reflection of background image.
That is, when only the thin silver film 12b is used, there is the possibility that the background image is reflected, since the thin silver film 12b acts as a regular reflector, and this is prevented by the thin zinc oxide film 12c.

In the above embodiment, for the sputter film 12 as a transparent conductive film, the number of layers of thin silver films 12b and thin zinc oxide films 12c (e.g., 3 layers for thin film 12b and 3 layers for thin film 12c) and film thickness (e.g., about 100 Å) are determined to obtain a surface resistance of about 2.7 Ω/cm²), but the present invention is not limited to this embodiment; for instance, even when the number of layers of thin silver film 12b and thin zinc oxide films 12c and film thickness (e.g., several hundred Å) are determined to obtain a surface resistance of about 3.0 Ω/cm² or less, the electromagnetic wave within frequency range of 30MHz - 130MHz can be intercepted by 10dB or more, and transmissivity of image light (visible rays) whose wavelength is within 400nm - 700nm can be controlled to the level of about 60%, while the transmissivity of near-infrared ray whose wave length is within 800nm - 1000nm can be controlled to the level of 10% or less (cutoff by 90% or more) just like the case of the above embodiment. When the surface resistance exceeds 3.0 Ω/cm², both the intercepting and cutoff characteristics decline, but still not only the electromagnetic wave having frequency within 30MHz - 130MHz can be intercepted but also the near-infrared having wavelength of 800nm - 1000nm can be cut off.

In the above embodiment, a grounding electrode is provided so that the transparent electrode film portion of the transparent conductive film 12 is connected thereto for grounding so that the electric charge induced in the transparent electrode film of the transparent conductive film 12 can be discharged to the ground, but the present invention is not limited to this embodiment; for instance, this embodiment is also applicable to a case where the transparent conductive film portion of the transparent conductive film 12 is not grounded by omitting the grounding electrode.

In the above embodiment, the transparent conductive film as sputter film 12 is first formed into a multilayer film comprising thin silver films 12b and thin zinc oxide films 12c laid alternately on one side of a PET film 12a, and then the PET film 12a is attached on the surface of filter substrate 11 for facilitating the process for providing the transparent conductive film on the filter substrate 11, but the present invention is not limited to this embodiment; for instance, the multilayer of alternately laid thin silver films 12b and thin zinc oxide film 12c may be formed as a transparent conductive film directly on the filter substrate 11 by omitting the PET film 12a.

In the above embodiment, the AR film 13 is provided to prevent the reflection of external light that causes the decline of contrast, but the present invention is not limited to this embodiment; for instance, the present invention is also applicable to the case where the AR film is omitted.

In the above embodiment, AN film is provided to prevent the occurrence of Newton's rings (development of bright and dark concentric circles), but the present invention is not limited to this embodiment; for instance, the present application is also applicable to the case where the AN film is omitted.

In the above embodiment, the filter substrate is formed from colored synthetic resin, but the present invention is not limited to this embodiment; for instance, the present invention is also applicable to the case where the filter substrate is formed from transparent synthetic resin alone. Further, the present invention is applicable to the case where the filter substrate is formed from transparent synthetic resin combined with a color filter designed to correct the color developed by PDP 1.

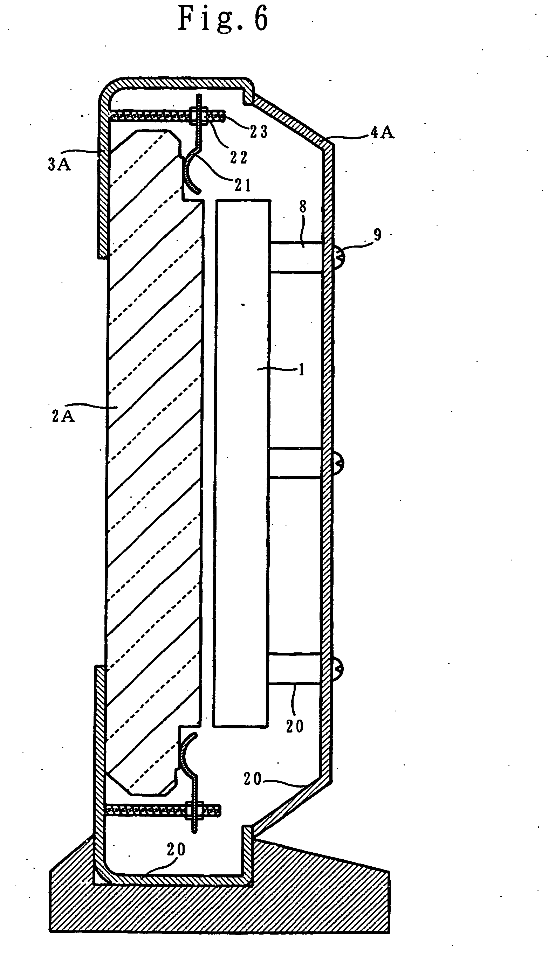

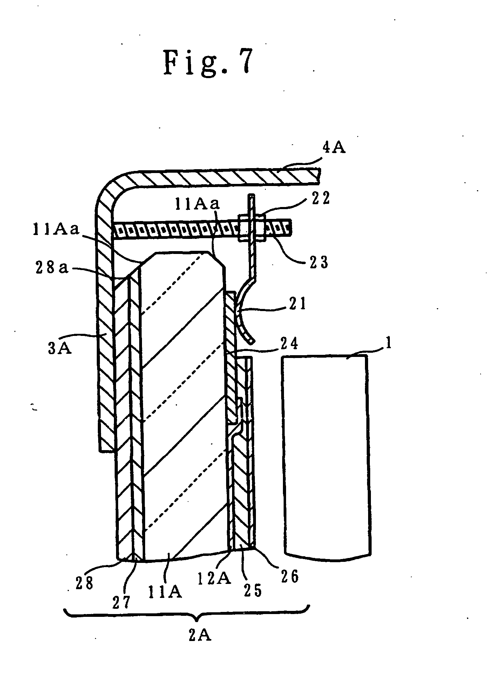

Next, the second embodiment of the present invention will be described referring to Fig. 6 and Fig. 7.

In Fig. 6 and Fig. 7, parts common to those in Fig. 1 and Fig. 3 are denoted by common reference numerals and symbols to avoid the duplication of the same descriptions. Fig. 6 shows an example of a large-size PDP device (e.g., 42-inch PDP device) with an optical filter incorporated thereinto. In Fig. 6, reference numeral 1 denotes the PDP; 2A, optical filter (hereinafter referred to simply as optical filter); 3A, front portion of casing; 4A, the rear portion of the casing. The peripheral portion of the optical filter 2A on the side of the PDP 1 is strongly in contact with the elastic portion of a fixing spring 21, the proximal portion of the fixing spring 21 being fixed securely to a conductive boss 23 with nut 22, while the conductive boss 23 is provided projecting inside of the front portion 3A of the casing. The PDP 1 is fixed to the rear portion 4A of the casing with a screw through fixing boss 8 to form a gap to the optical filter 2A.

As shown in Fig. 7, the optical filter 2A comprises a filter substrate 11A formed from reinforced glass, a transparent conductive film 12A and an electrode 24 fixed on one surface (surface on the side of PDP 1) of the filter substrate 11A, an anti-reflection film 26, securely attached with transparent bonding agent 25 on the upper surface of the transparent conductive film 12A and upper surface of electrode 24, and an anti-reflection colored film 28 securely attached with a bonding agent 27 on the other surface of the filter substrate 11.

The filter substrate 11A is formed from a reinforced glass plate of about 3mm thick (e.g., 3.2mm thick), which is first heated to about 600°C and then cooled by moving air for increasing strength and made available as an economical and relatively lightweight substrate of optical filter. The filter substrate 11A is not limited to that manufactured by moving-air cooling process; it may be of chemically reinforced glass, and its thickness is not necessarily limited to about 3mm.

The corners of the filter substrate 11A, each being formed between its wider surface and side surface, are beveled to form beveled surfaces 11Aa and 11Aa. These beveled surfaces are provided to prevent the substrate 11A from being damaged by coming into contact with other object during handling.

The electrode 24 is formed by printing a conductive metal (e.g., conductive paste) on peripheral portion of one surface of the filter substrate 11A, while the transparent conductive film 12A is formed by sputtering method covering almost all of one surface of the filter substrate 11A not including the peripheral surface thereof, so that the area covered by sputtering overlaps the internal peripheral portion of the electrode 24 to be connected electrically therewith. The transparent conductive film 12A is formed in a fashion similar to that of the sputter film 12 as transparent conductive film of the first embodiment. However, unlike the case of the first embodiment wherein the transparent conductive film is formed on the PET film 12a, the thin silver films 12b and thin zinc oxide films 12c are formed by sputtering method directly on one surface of the filter substrate 11A as a multi-layer film comprising thin silver films 12b and thin zinc oxide films 12c which are laid alternately, as shown in Fig. 4, so that a thin zinc oxide film becomes the top layer and to a thickness (e.g., to about 100 Å) with which a surface resistance of about 2.6 Ω/cm² can be obtained. When the surface resistance is set to about 2.6 Ω/cm², the amount of radiation of the electromagnetic wave leaking outside from the PDP 1 can be intercepted to the level or lower than the level required by safety regulation or the like while maintaining required transmissivity (e.g., 60%) for the visible rays as in the case of the first embodiment.

The anti-reflection film 26 is an optical thin film comprising a plurality of films formed on the surface of a transparent film by vacuum evaporation method by using materials having different refractive indexes, or is an optical thin film comprising a transparent film and fluororesin film applied thereon, which is designed to prevent the display light from PDP 1 or external light.

The anti-reflection colored film 28 comprises a fluorine-base film containing pigments serving as coloring matters for correcting the colors developed by the PDP 1 and an optical thin film, similar to the anti-reflection film 26, formed thereon for preventing the reflection of the light. The peripheral portion of the anti-reflection colored film 28 is beveled so that the beveled surface continues flush with one of the beveled faces 11Aa of the filter substrate 11A so that the film can be prevented from coming off during handling.

As shown in Fig. 6, a conductive film 20 is formed on the inside surface of the front portion 3A of the casing, inside surface of rear portion 4A of the casing, surface of fixing boss 8 and the like, whereby the transparent conductive film 12A of the optical filter 2A is made to be connected with the metal portion 1a (grounding portion) on the back of the PDP 1 through the grounding electrode 24, fixing spring 21, nut 22, conductive boss 23 and conductive film 20 to discharge to the ground the electric charge induced in the transparent conductive film 12A by the electromagnetic wave radiated from the body 1b of the PDP 1.

Then, as shown in Fig. 6 and Fig. 7, when the optical filter 2A is installed in front of the PDP 1, the image light output from the PDP 1 passes through the optical filter 2A, and the electromagnetic wave leaking from the PDP1 is intercepted by the optical filter 2A, while the near-infrared ray radiated from the PDP 1 is cut off by the optical filter 2A. According to the result of experiment, the intercepted amount (attenuation) of electromagnetic wave is 10dB or more (dB µ V/m) within frequency range of 30MHz - 130MHz. Therefore, when combined with the electromagnetic wave intercepting ability of the PDP 1 itself, the available intercepting ability is sufficient to clear the level of leakage of electromagnetic wave allowed for the information processing equipment under the requirements of the Electrical Equipment Control Law, VCCI, FCC, EN and the like. Further, for the visible rays and near-infrared ray, the optical filter passes the visible rays having wavelength of 400nm - 700nm by about 60% and passes about 10% (intercepting 90% or more) or less of near-infrared ray having wavelength of 800nm - 1000nm. Therefore, interference of the PDP with the operation of infrared-ray remote control equipment or the communication equipment installed in the vicinity can be prevented.

Further, the filter substrate 11A is formed from reinforced glass, so that, when the optical filter 2A is installed in front of the PDP 1, the warping and resultant deflection of the filter substrate 11A due to the heat given off for display by the PDP will not occur, and thus degrading of the quality of displayed picture can be prevented.

Further, the filter substrate 11A is formed from reinforced glass, and so its thickness can be made smaller than that of the filter substrate formed from ordinary glass.

Further, the reflection of the display light from the PDP 1 and the external light are prevented by the anti-reflection film 26 and the anti-reflection colored film 28 provided on both surfaces of the filter substrate 11A respectively, whereby the decline of contrast is prevented, and the colors developed by the PDP 1 are corrected for easier maintenance of white balance and for preventing the broken pieces of the PDP 1 from scattering around if it should be broken.

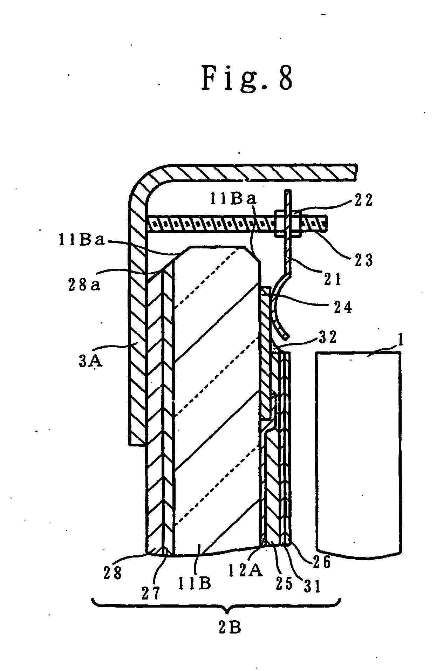

Next, the third embodiment of the invention will be described referring to Fig. 8. In Fig. 8, for the parts common to those shown in Fig. 6 and Fig. 7, the common reference numerals or symbols are assigned so that duplication of the same descriptions can be avoided. Fig. 8 shows an example of a large-size PDP device with an optical filter. In Fig. 8, numeral 1 denotes the PDP; 2B, the optical filter for the PDP (hereinafter referred to simply as optical filter); 3A, the front portion of the casing. The elastic portion of the fixing spring 21 is strongly pressed against the peripheral portion of the optical filter 2B on the side of the PDP 1. The proximal end portion of the fixing spring 21 is fastened to conductive boss 23 with the nut 22, while the conductive boss 23 projects inside of the front portion 3A of the casing, whereby the optical filter 2B is fixed to the front portion 3A of the casing. A gap is formed between the PDP 1 and the optical filter 2B.

The optical filter 2B comprises a filter substrate 11B, a transparent conductive film 12A and an electrode 24 which are securely attached on one surface (on the side of PDP 1) of the filter substrate 2B, a transparent moisture-proof film 31 securely attached with a transparent bonding agent 25 on the top surface of the transparent conductive film 12A and that of the electrode 24, an anti-reflection film 26 attached on the top surface of the moisture-proof film 31 with the transparent bonding agent (not shown), a moisture-proof sealing member 32 and a anti-reflection colored film 28 securely attached on the other surface of the reinforced filter substrate 2B with a transparent bonding agent 27.

The filter substrate 11B is provided with bevels 11Ba and 11Ba, which are similar to those of the second embodiment, while the peripheral portion of the anti-reflection colored film 28 is also provided with a bevel 28a continuing flush with one of the bevels 11Ba. The moisture-proof film 31 is formed from a transparent airtight film such as the PET film and provided not only for covering whole surface of the transparent conductive film 12A but also overlapping with the inside peripheral area of the grounding electrode 24 corresponding to the periphery of the transparent conductive film 12A.

The peripheral portions of the transparent bonding agent 25 and the boundary edge between the moisture-proof film 31 and the transparent bonding agent 25 are sealed with the sealing member 32, whereby the transparent conductive film 12A (especially, thin silver film) is prevented from being corroded by the water vapor in the external air.

The inside surface of the front portion 3A of the casing, the inside surface of the rear portion 4A of the casing (not shown in Fig. 8) and the surface of fixing boss 8 (not shown in Fig. 8) are provided with conductive film 20 by conductive film forming process, whereby the transparent conductive film 12A of the optical filter 2B is connected to the metal portion (for grounding) 1a (not shown) of the back of the PDP 1 through the grounding electrode 24, fixing spring 21, nut 22, conductive boss 23 and conductive film 20 to discharge to the ground the electric charge induced in the transparent conductive film 12A by the electromagnetic wave radiated from the PDP1.

Then, as shown in Fig. 8, when the optical filter 2B is installed in front of the PDP 1, the image light output from the PDP 1 is transmitted by the optical filter 2B, and the electromagnetic wave leaking from the PDP 1 is intercepted by the optical filter 2B, while the near-infrared ray radiated from the PDP 1 is also cut off by the optical filter 2B. According to the result of experiment, like the case of the second embodiment, the intercepted amount (attenuation) of the electromagnetic wave by the optical filter 2B is 10dB or more (dB µV/m) within frequency range of 30MHz - 130MHz.
Therefore, when combined with the electromagnetic wave intercepting ability of the PDP 1 itself, the available electromagnetic wave intercepting ability is large enough to clear the leakage level limit of the electromagnetic wave required by the Electric Equipment Control Law, VCCI, FCC, EN and the like. Further, for the visible rays and near-infrared ray, like the case of the first embodiment shown in Fig. 5, the transmissivity of the visible rays having wavelength of 400nm - 700nm is about 60%, and the transmissivity of near-infrared ray having wavelength of 800nm - 1000nm is about 10% or less (intercepting 90% or more). Therefore, the interference with the operation of nearby infrared-ray remote control equipment or optical communication equipment by the near-infrared ray can be prevented.

Further, all the surfaces of the transparent conductive film 12A is covered with the moisture-proof film 31, so that, coupling with sealing by the sealing member 32, the transparent conductive film 12A (especially, thin silver film) is prevented from being corroded by the water vapor in the external air.

Further, the filter substrate 11B being formed from glass, the filter substrate 11B installed in front of the PDP 1 will not be warped due to the heat given off for display by the PDP 1, so that the degradation of the quality of displayed picture due to local warping of the optical filter can be prevented.

Further, the anti-reflection film 26 and the anti-reflection colored filter 28 provided on both surfaces of the filter substrate 11B respectively prevent the reflection of the display light from the PDP 1 and external light, thereby preventing the decline of the contrast and correcting the colors developed by the PDP 1 for easier maintenance of white balance, while preventing broken pieces of the filter substrate 11B from scattering if it should be broken.

The second and the third embodiments are concerned with the cases where a gap is provided between the optical filter 2A and the PDP 1 and the optical filter 2B and the PDP 1, but the present invention is not limited to these embodiments; for instance, the invention is also applicable to the cases where the gap is not provided between the optical filter 2A and the PDP 1 and between the optical filter 2B and the PDP 1 like the case of the first embodiment. Further, the invention is applicable to the case where the AN film similar to that of the first embodiment is provided on the surface of the optical filter 2A and on the surface of the optical filter 2B on the side of the PDP 1.

In the above embodiment, the case where the display panel is a PDP, but the present invention is not limited to such a case but also applicable to display panels from which unnecessary electromagnetic wave or near-infrared ray leaks.

### INDUSTRIAL APPLICABILITY

As described in the foregoing, the optical filter for the display panel according to the present invention is suited for being installed in front of the display panel (e.g., PDP) of display device for allowing the display light (visible rays) output from display panel to pass and the electromagnetic wave leaking from display panel, to be intercepted while suppressing the leakage level of the electromagnetic wave to or below the leakage level limit required for the information processing equipment and the like by the regulations and preventing the interference with the operation of nearby remote control equipment or communication equipment by the near-infrared ray radiated from the display panel.

## Claims

1. An optical filter (2) for a plasma display panel, the filter comprising:
a filter substrate (11) formed from glass or from reinforced glass; and,
a transparent conductive film (12) for transmitting visible electromagnetic waves and intercepting electromagnetic waves having a frequency of 30 MHZ - 130 MHZ and cutting off near-infrared electromagnetic waves having a wavelength of 800 nm - 1000 nm, the transparent conductive film comprising thin silver films and thin zinc oxide films which are laid alternatively to form a multilayer film,
**characterised in that** the multilayer film has a surface resistance of 3Ω/cm² or less, **in that** the transparent conductive film (12) is connectable to a grounding electrode and **in that** the corners (11Aa, 11Ba) of the filter substrate (11), each formed between a wider surface and a side surface thereof, are bevelled.

2. An optical filter for a plasma display panel according to claim 1, wherein a coloured film (28) is provided for correcting colours developed by the display panel.

3. An optical filter for a plasma display panel according to claim 2, wherein coloured film (28) for correcting the colours developed by the display panel is securely attached on the surface of the filter substrate (11), and the peripheral portion of the coloured film (28) is bevelled to continue flush with the bevel (11Aa, 11Ba) of the filter substrate (11).

4. An optical filter for a plasma display panel according to any one of the preceding claims, wherein an anti-reflection film (13, 26, 28) is provided for preventing reflection of external light.

5. An optical filter for a plasma display panel according to any one of the preceding claims, wherein a Newton's rings prevention film (14) is provided for preventing occurrence of Newton's rings.

6. An optical filter for a plasma display panel according to any one of the preceding claims, wherein a moisture-proof film (31) is provided for covering the exposed surface of the transparent conductive film (12).

## Patentansprüche

1. Optisches Filter (2) für einen Plasmabildschirm, wobei das Filter umfaßt:
ein Filtersubstrat (11), das aus Glas oder verstärktem Glas gebildet ist; und
einen transparenten, leitenden Film (12) zum Durchlassen von elektromagnetischen Wellen im sichtbaren Bereich und Abfangen von elektromagnetischen Wellen mit einer Frequenz von 30 MHz bis 130 MHz und Abschneiden von elektromagnetischen Wellen im nahen Infrarot, die eine Wellenlänge von 800 nm bis 1000 nm haben, wobei der transparente, leitende Film dünne Silberschichten und dünne Zinkoxidschichten hat, die abwechselnd abgelegt sind, um einen mehrschichtigen Film zu bilden,
**dadurch gekennzeichnet, daß** der mehrschichtige Film einen Oberflächenwiderstand von 3 Ohm/cm² oder weniger hat, daß der transparente, leitende Film (12) an eine Masseelektrode anschließbar ist und daß die Ecken (11 Aa, 11Ba) des Filtersubstrats (11), die jeweils zwischen einer breiteren Oberfläche und einer ihrer seitlichen Oberflächen ausgebildet sind, abgeschrägt sind.

2. Optisches Filter für einen Plasmabildschirm nach Anspruch 1, wobei ein Farbfilm (28) vorgesehen ist, um Farben zu korrigieren, die von dem Bildschirm entwickelt werden.

3. Optisches Filter für einen Plasmabildschirm nach Anspruch 2, wobei der Farbfilm (28) zum Korrigieren der Farben, die von dem Bildschirm entwickelt werden, sicher an der Oberfläche des Filtersubstrats (11) befestigt ist und der periphere Abschnitt des Farbfilms (28) abgeschrägt ist, um fluchtend zu verlaufen zu der Schräge (11Aa, 11Ba) des Filtersubstrats (11).

4. Optisches Filter für einen Plasmabildschirm nach einem der vorstehenden Ansprüche, wobei ein Antireflexfilm (13, 26, 28) vorgesehen ist, um eine Reflektion von Außenlicht zu verhindern.

5. Optisches Filter für einen Plasmabildschirm nach einem der vorstehenden Ansprüche, wobei ein Film (14) zum Verhindern Newton'scher Ringe vorgesehen ist, um das Auftreten Newton'scher Ringe zu verhindern.

6. Optisches Filter für einen Plasmabildschirm nach einem der vorstehenden Ansprüche, wobei ein feuchtigkeitsundurchlässiger Film (31) vorgesehen ist, um die freigelegte Oberfläche des transparenten, leitenden Films (12) abzudecken.

## Revendications

1. Filtre optique (2) pour écran à plasma, le filtre comprenant :
un substrat de filtre (11) formé de verre ou de verre renforcé ; et
un film conducteur transparent (12) pour transmettre des ondes électromagnétiques visibles et intercepter des ondes électromagnétiques ayant une fréquence de 30 MHZ - 130 MHZ et couper les ondes électromagnétiques du proche infrarouge ayant une longueur d'onde de 800 nm -1000 nm, le film conducteur transparent comprenant de minces films d'argent et de minces films d'oxyde de zinc qui sont disposés en alternance pour former un film multicouches,
**caractérisé en ce que** le film multicouches a une résistance superficielle de 3 Ω/cm² ou moins, **en ce que** le film conducteur transparent (12) est connectable à une électrode de terre, et **en ce que** les coins (11Aa, 11Ba) du substrat de filtre (11), formés chacun entre une surface plus large et une surface latérale de celui-ci, sont biseautés.

2. Filtre optique pour écran à plasma selon la revendication 1, dans lequel un film coloré (28) est prévu pour corriger les couleurs développées par l'écran d'affichage.

3. Filtre optique pour écran à plasma selon la revendication 2, dans lequel le film coloré (28) pour corriger les couleurs développées par l'écran d'affichage est solidement fixé sur la surface du substrat de filtre (11), et la partie périphérique du film coloré (28) est biseautée pour être en affleurement continu avec le biseau (11Aa, 11Ba) du substrat de filtre (11).

4. Filtre optique pour écran à plasma selon l'une quelconque des revendications précédentes, dans lequel un film antireflet (13, 26, 28) est prévu pour empêcher la réflexion de lumière externe.

5. Filtre optique pour écran à plasma selon l'une quelconque des revendications précédentes, dans lequel un film de prévention contre les anneaux de Newton (14) est prévu pour empêcher l'occurrence d'anneaux de Newton.

6. Filtre optique pour écran à plasma selon l'une quelconque des revendications précédentes, dans lequel un film à l'épreuve de l'humidité (31) est prévu pour couvrir la surface exposée du film conducteur transparent (12).
